Europäisches Patentamt

European Patent Office

Office européen des brevets

(19)

(11) Numéro de publication: **0 188 968**
A1

# (12) DEMANDE DE BREVET EUROPEEN

(21) Numéro de dépôt: **85402621.8**

(22) Date de dépôt: **24.12.85**

(51) Int. Cl.⁴: **G 11 C 5/00,** G 06 F 1/00,
H 05 K 7/14

(30) Priorité: **17.01.85 FR 8500671**

(43) Date de publication de la demande: **30.07.86**
**Bulletin 86/31**

(84) Etats contractants désignés: **AT BE CH DE GB IT LI LU
NL SE**

(71) Demandeur: **ELECTRONIQUE SERGE DASSAULT,
80, avenue Marceau, F-75008 PARIS (FR)**

(72) Inventeur: **Prevost, Jacques, 30 bis, rue des Landes,
F-78400 Chatou (FR)**
Inventeur: **Giraudet de Boudemange, Guy, 9, rue
Victorien Sardou, F-75016 Paris (FR)**
Inventeur: **Christol, Guy, 31-33, rue Cortambert,
F-75016 Paris (FR)**

(74) Mandataire: **Plaçais, Jean-Yves et al, Cabinet
Netter 40, rue Vignon, F-75009 Paris (FR)**

(54) Dispositif d'enregistrement/lecture à mémoire électronique modulaire.

(57) Un coffret (100) comporte un ou plusieurs logements (130) dans chacun desquels peut s'insérer un module de mémoire (MM). Muni de rainures latérales, celui-ci est guidé par des languettes (111 et 112) du coffret. Sa partie arrière comporte des orifices venant en prise sur des pions de centrage (PC11 et PC12), pour assurer l'enfichage de l'élément de connecteur mâle (C1) du module de mémoire sur un élément de connecteur femelle (C2) monté flottant dans l'appareil. Un interrupteur (IC10) détecte l'enfichage complet des deux éléments de connecteur l'un sur l'autre. Cet enfichage est mené à bien par l'action d'un secteur cranté (121) sur un segment de crémaillère (SC21) monté à l'extrémité avant de l'une des rainures. Le secteur de crémaillère (121) est actionné par un levier (125) qui vient se fermer sur l'avant du logement (130) et se verrouiller par vissage en (128) à l'aide d'un bouton moleté (127).

ESD Aff. 314.

1

# Dispositif d'enregistrement/lecture à mémoire électronique modulaire.

L'invention concerne les organes de mémoire utilisables dans les circuits électroniques.

La Demanderesse a constaté qu'il devient maintenant souhaitable, en beaucoup d'applications, d'utiliser des organes de mémoire modulaires, aisément amovibles.

Les cassettes de mémoire magnétique possèdent cette propriété. Mais le temps d'accès aux informations qu'elles contiennent est bien entendu prohibitif.

Il n'en va pas mieux avec les autres mémoires magnétiques, telles que disquettes ou disques durs amovibles; si leur temps d'accès est meilleur, elles nécessitent le respect de précautions d'emploi et de stockage qui les rendent inapplicables en pratique.

On connaît encore les mémoires électroniques, c'est-à-dire celles dans lesquelles l'entrée/sortie dans l'élément physique de mémoire s'effectue par voie de signaux électriques. Des réalisations de ce genre existent; mais elles n'atteignent ni une grande capacité de mémoire, ni la très grande sécurité exigée dans certaines applications auxquelles la Demanderesse s'intéresse, comme l'aviation.

En particulier, plutôt que d'accroître la capacité de mémoire centrale des calculateurs embarqués, la Demanderesse estime préférable d'utiliser des mémoires de masse modulaires, utilisables aussi bien au sol que dans l'aéronef, et chargées par l'intermédiaire d'un bus.

Le problème de base est donc de réaliser des mémoires modulaires de masse, dont la capacité est au moins de l'ordre du Mégabit, et largement extensible. Ce problème est compliqué par le fait que ces mémoires doivent présenter une grande fiabilité, un faible volume, et surtout une bonne tenue dans des conditions d'environnement extrêmes, comme -55/+125° en température, et des vibrations importantes.

La présente invention vient apporter une solution à ce problème.

De manière connue, il est fait usage d'un dispositif pour l'enregistrement et la lecture d'informations, dans lequel un organe de mémoire électronique modulaire, en forme de boîtier parallélépipédique plat, peut être mis en coopération avec un appareil de lecture/écriture, pourvu d'un logement propre à recevoir ledit boîtier.

Selon les différents aspects de l'invention :

- l'organe de mémoire est composé de circuits intégrés hybrides équipés de puces de mémoire électronique, définissant une capacité de mémoire d'au moins 0,25 Mégabit;

- le boîtier comporte en partie arrière un connecteur mâle, relié à ses circuits hybrides internes, et possédant au moins huit broches de données, quinze broches d'adresses,quatre broches d'écriture, ainsi que des broches d'alimentation,d'effacement et de validation;

ce connecteur mâle étant propre à coopérer avec un connecteur femelle homologue, monté flottant au fond du logement de l'appareil de lecture/écriture;

- le boîtier comporte sur ses petites faces latérales des glissières, dont au moins une partie est électriquement conductrice, et qui sont propres à coopérer avec des organes de guidage montés en regard dar.s ledit logement, et pourvues de parties conductrices venant au contact de celles des glissières et reliées à la masse de l'appareil;

- des moyens de centrage coopérants sont prévus sur le boîtier et dans le logement de l'appareil, de part et d'autre de leurs connecteurs respectifs;

- le boîtier de mémoire porte, à l'extrémité avant de l'une de ses glissières, un segment de crémaillère propre à coopérer avec un segment de roue dentée monté à rotation, en regard, dans l'appareil de lecture/écriture, lequel comporte en outre des moyens de commande de la roue dentée permettant la mise en place et l'extraction du boîtier de mémoire; et

- l'appareil de lecture/écriture, qui comprend des moyens électroniques de lecture/écriture dans lesdits circuits hybrides, est muni d'au moins un détecteur de la présence du boîtier de mémoire en position complètement enfichée, lequel détecteur interdit dans le cas contraire toute écriture d'informations dans le boîtier de mémoire, de préférence tout échange d'informations avec celui-ci.

Dans un mode de réalisation actuellement préféré par la Demanderesse, les puces sont des mémoires de type EEPROM, assorties de registres tampons d'écriture, et organisées en mots d'au moins 8 bits. Dans un mode de réalisation avantageux, les puces sont organisées en au moins 128 kilos-mots de 16 bits, soit 2 Mégabits.

Pour leur part, les glissières sont, de préférence, placées dans un plan principal du connecteur, c'est-à-dire dans un plan parallèle au plan défini par l'axe central du connecteur et la direction de sa grande dimension. Les glissières sont alors constituées de rainures latérales du boîtier, coopérant avec des languettes homologues de son logement.

Pour sa part, le logement de l'appareil comporte de préférence, en son entrée, et à l'opposé du segment de roue dentée, un galet libre propre à coopérer avec la glissière du boîtier qui est dépourvue de crémaillère.

Les moyens de commande du segment de roue dentée sont avantageusement constitués d'un levier muni d'un rappel élastique à l'ouverture, et propre à se loger avec fixation sur la face avant de l'appareil, en position de fermeture. Les moyens de centrage, placés de préférence au voisinage du plan principal précité, comprennent typiquement des tétons du logement, qui sont propres à coopérer avec des orifices du boîtier.

Dans l'un de ces tétons ou au voisinage de celui-ci, on pourra loger avantageusement le détecteur de présence du boîtier de mémoire.

Selon un autre aspect de l'invention, le boîtier de mémoire comporte un organe à deux positions, et il est prévu dans le logement un palpeur propre à détecter la position de cet organe, qui est avantageusement une vis montée à l'arrière du boîtier. Cette vis peut permettre d'indiquer si l'écriture est ou non autorisée dans le module de mémoire, ou servir à d'autres fins du même genre.

Bien entendu, l'appareil de lecture/écriture peut comporter plusieurs logements adjacents propres à recevoir autant de modules de mémoire respectifs.

Les moyens électroniques de lecture/écriture incorporés à l'appareil comportent au moins une unité d'interface avec le ou les modules de mémoire et une unité de connexion avec un bus externe.

Ce type de mémoire a l'avantage de pouvoir être adressé directement de manière aléatoire. Cette possibilité, associée à l'utilisation d'une unité de traitement avec son unité de mémoire propre, permet une gestion locale des modules de mémoire, l'unité de traitement permettant alors par exemple l'accès aux modules de mémoire par adressage direct, par adressage indirect, ou par adressage de fichier.

D'autres caractéristiques et avantages de l'invention apparaîtront à l'examen de la description détaillée qui va suivre, ainsi que des dessins annexés, sur lesquels :

- la figure 1 est une vue schématique en perspective d'un dispositif de lecture/écriture selon l'invention, comportant deux modules de mémoire;

- la figure 2 est une vue en perspective d'un module de mémoire selon l'invention;

- les figures 3A à 3E sont cinq vues correspondantes d'un module de mémoire selon l'invention;

- les figures 4A et 4B sont deux vues de l'appareil de lecture/écriture selon l'invention, la figure 4A étant une vue en élévation avec coupe partielle, tandis que la figure 4B est une vue de dessus;

- la figure 5 est une autre vue de dessus, capot supérieur enlevé, de l'appareil selon l'invention;

- la figure 6 est un schéma de principe des moyens électroniques de lecture/écriture incorporés à l'appareil selon l'invention;

- les figures 7A à 7C sont des chronogrammes de lecture, écriture, effacement; et

- les figures 8 et 9, illustrent plus en détail la constitution du module de mémoire.

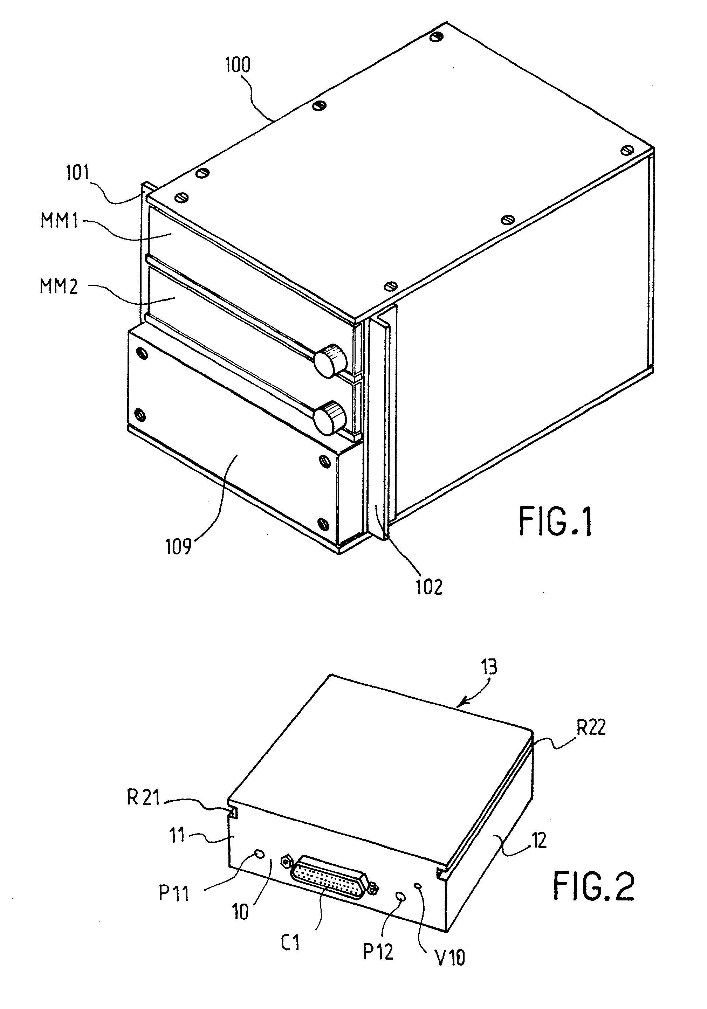

Sur la figure 1, l'appareil de lecture/écriture se compose d'un coffret 100, de forme générale parallélépipédique, muni latéralement près de sa face avant de deux cornières 101 et 102. La face avant du caisson est ouverte en partie supérieure pour définir l'entrée de deux logements propres à recevoir respectivement deux modules de mémoire MM1 et MM2. Le bas de la face avant est fermé par un couvercle 109, derrière lequel se trouve l'unité électronique d'écriture/lecture que comporte l'appareil.

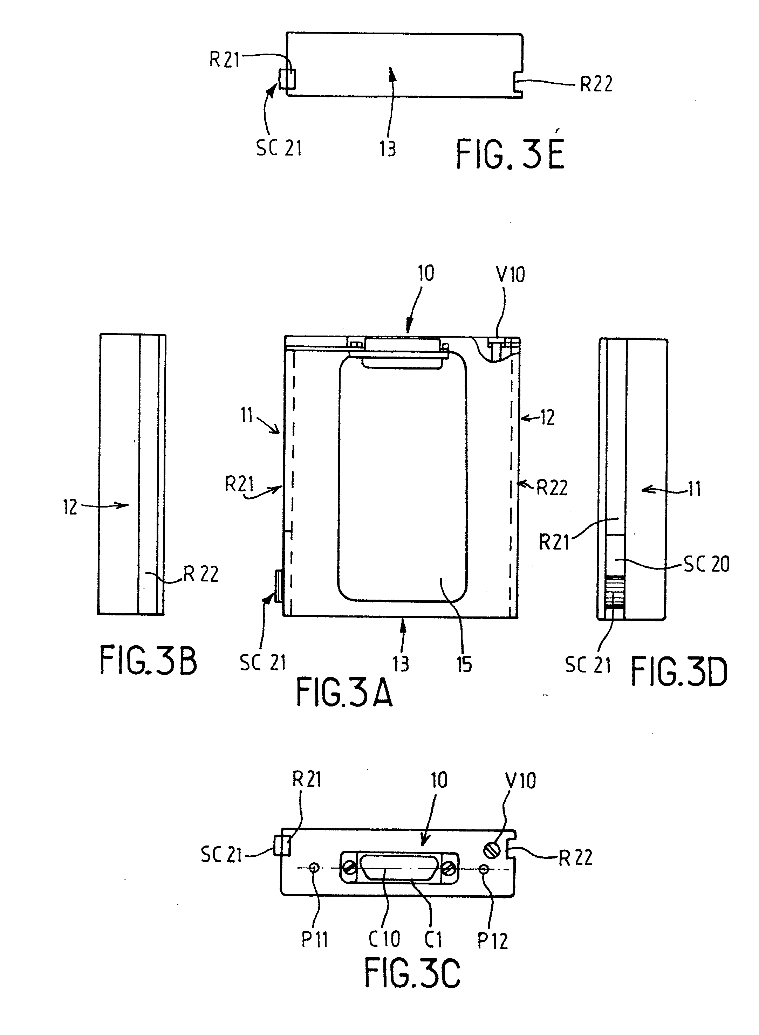

Il est maintenant fait référence aux figures 2 et 3, pour la description d'un module de mémoire.

Un module de mémoire se compose d'un boîtier de forme générale parallélépipédique, comportant une face avant 13, une face arrière 10 sur laquelle est prévu un élément de connecteur C1, et deux faces latérales 11 et 12. Le boîtier est fermé par une face de dessus et de dessous, non représentée.

L'élément de connecteur C1 est par exemple le modèle Cannon MDVB 1-51P. Ce connecteur comporte 51 broches mâles. Du fait de sa forme en trapèze à coins arrondis, il n'a besoin d'aucun détrompage électrique.

Ce connecteur possède un plan principal dont la trace est C10 sur la figure 3C. Cette trace, qui passe par les points de fixation du connecteur C1, s'étend parallèlement à la grande dimension de celui-ci.

Dans ce plan principal C10 sont prévus deux orifices, P11 et P12, de part et d'autre du connecteur C1.

La figure 3C fait encore apparaître deux rainures latérales R21 et R22 que comporte le module dans ses parois latérales 11 et 12. Ces rainures définissent ensemble un plan parallèle au plan principal précité.

L'une de ces rainures, ici la rainure R21, comporte près de l'avant 13 du module, une pièce SC20 qui définit une saillie en forme de crémaillère SC21, que l'on voit dépasser de la paroi latérale 11 sur les figures 3A, 3C et 3E.

Enfin, sur la face arrière du module de mémoire, il est prévu une vis V10 susceptible de prendre deux positions. Dans l'une de ces positions, la vis est rentrée à l'intérieur du module. Dans l'autre position, elle fait saillie sur la face arrière 10 de ce même module. Cette vis permettra par exemple d'indiquer que l'écriture dans le module est ou non autorisée, à l'aide d'un autre interrupteur tel que IC10.

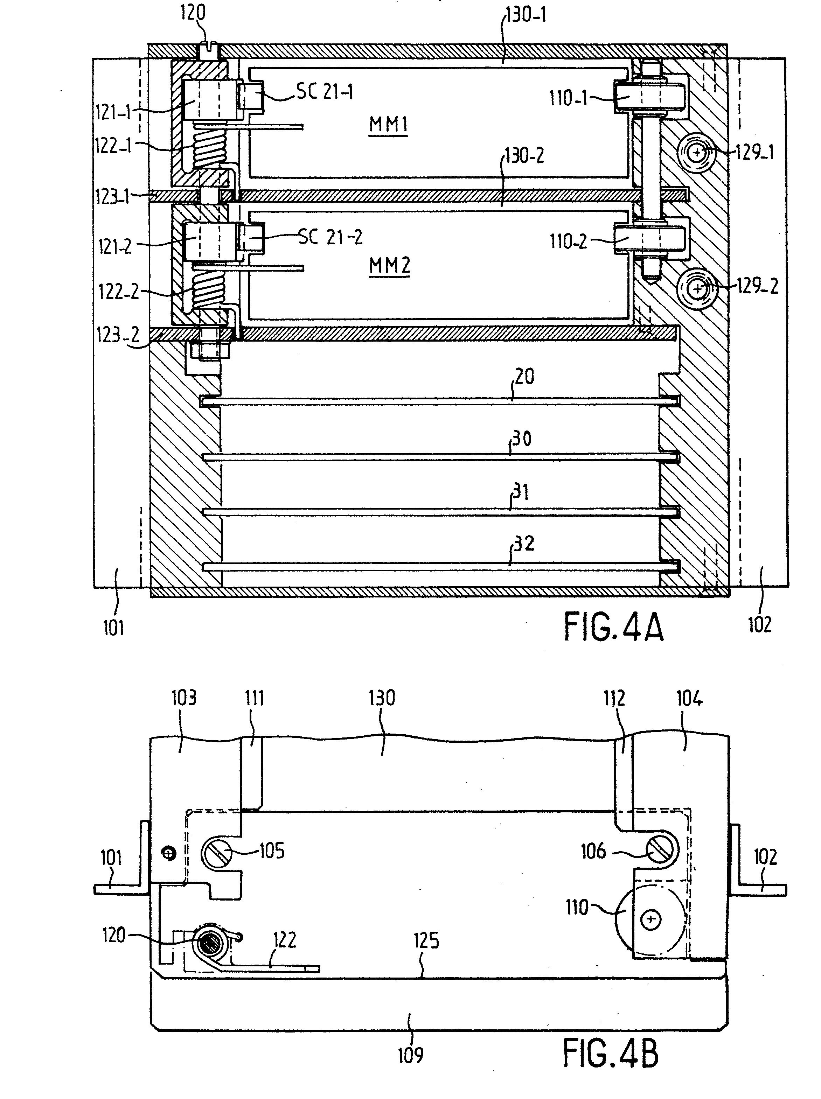

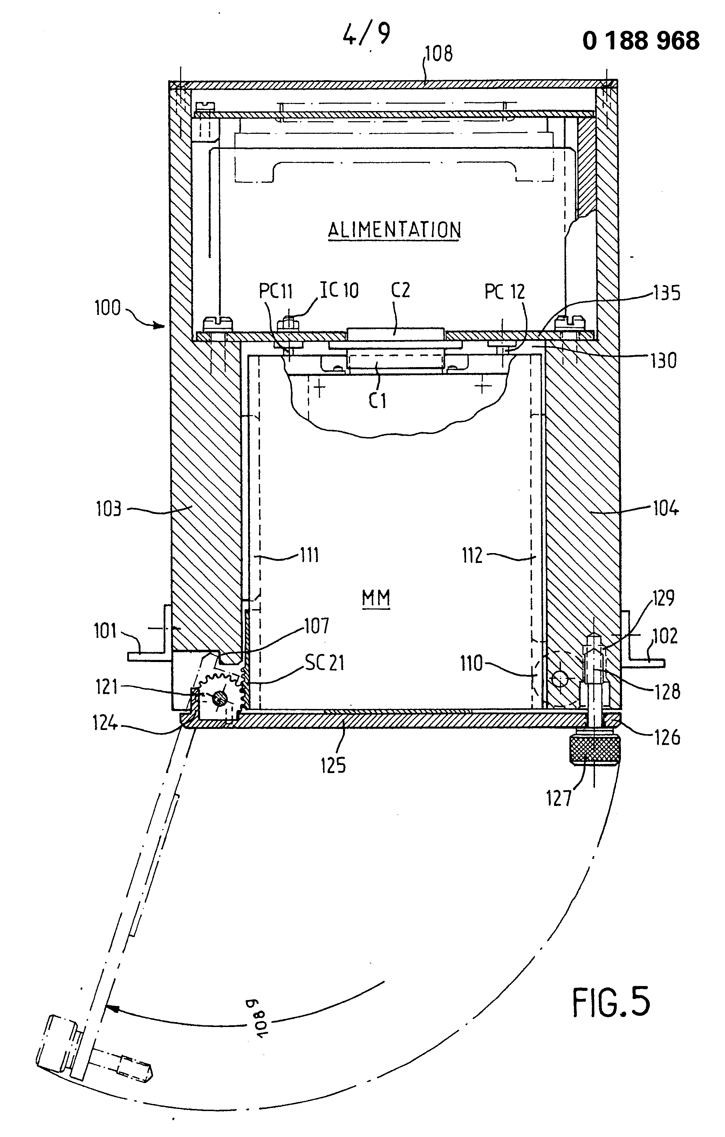

Il est maintenant fait référence aux figures 4A, 4B et 5, ainsi qu'à la figure 1.

Sur la figure 4A, le couvercle 109 est enlevé, laissant apparaître quatre plaques de circuit imprimé 20, 30, 31 et 32, qui correspondent respectivement à une interface, à une unité de traitement, à des circuits de mémoire, et à un circuit de connexion vers un bus.

Au-dessus sont représentés deux modules de mémoire MM1 et MM2, dans leurs logements respectifs 130 (sur la figure 4B, le module de mémoire est enlevé).

Le châssis de l'appareil comporte deux montants latéraux 103 et 104, sur lesquels sont fixées des languettes 111 et 112, propres à venir coopérer avec les rainures R21 et R22 de l'un des modules de mémoire. La languette 111 s'interrompt la première, vers l'avant, pour laisser place au segment de crémaillère SC21 du module enfiché. Le module de mémoire est ainsi guidé en translation dans un plan parallèle au plan principal du connecteur C1 (figure 5).

Ceci l'amène au voisinage de l'élément de connecteur C2, qui est monté flottant sur une plaque 135, que comporte l'appareil 100, et qui définit le fond de ces logements.

Sur cette même plaque 135 sont également montés deux pions de centrage PC11 et PC12, qui vont pouvoir s'introduire dans les orifices P11 et P12 du module de mémoire, afin de permettre la première introduction de l'élément de connecteur mâle C1 dans l'élément de connecteur femelle C2.

Avantageusement, dans l'un des pions de centrage PC11, ou au voisinage de celui-ci, il est prévu un interrupteur IC10 (figure 5), qui permet de déterminer que l'élément de connecteur mâle C1 d'un module de mémoire est complètement introduit dans le connecteur femelle C2 de l'appareil 100.

IC10 est par exemple un interrupteur tel que le modèle 83 1295 de la Société CROUZET dont le contact, ouvert lorsque la cassette est absente, est fermé par action de la cassette lorsque celle-ci est en place, ou inversement.

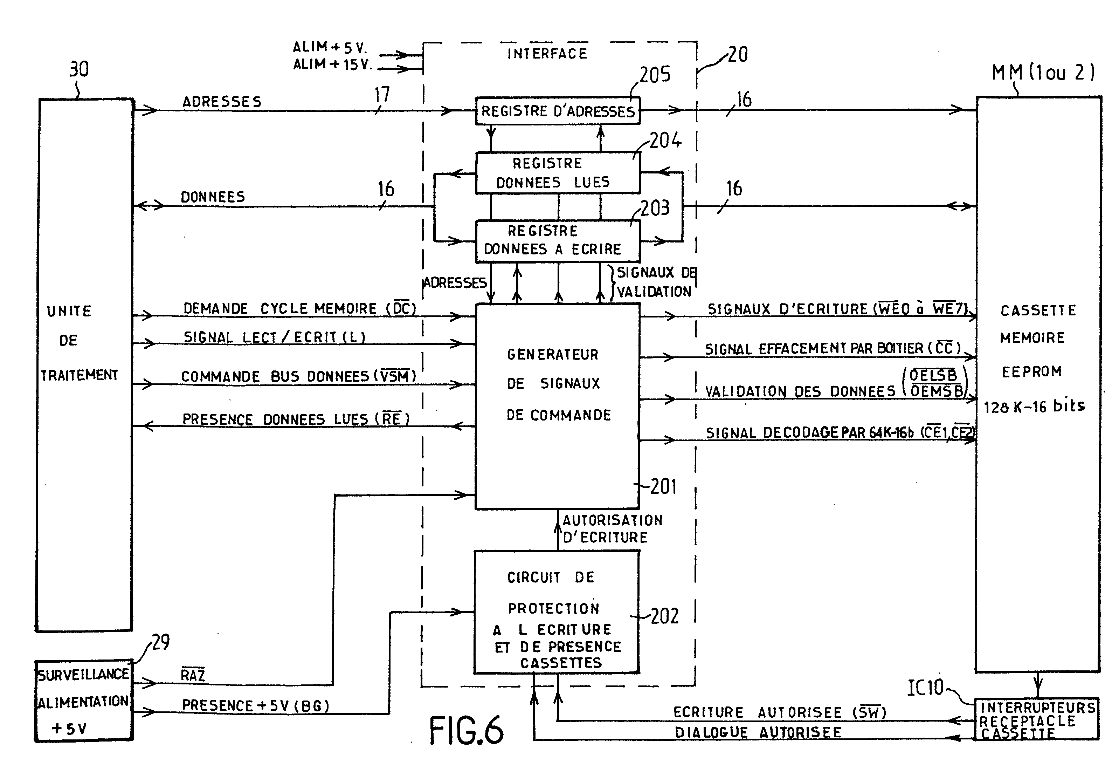

Entre la plaque 135 et la plaque arrière 108 du module de mémoire sont logés des circuits d'alimentation, qui peuvent être de type connu, afin de fournir des tensions de 5 volts et +/_ 15 volts (voir figure 6).

A l'avant de l'appareil, et dans chaque logement que comporte celui-ci, il est prévu à droite un galet fou 110-1 ou 110-2, suivant le module de mémoire considéré.

La section droite de chaque galet, dans la mesure où elle fait saillie à l'intérieur du logement, est alignée sur la languette 112 correspondante. Le cas échéant, le galet est monté sur roulement à billes.

A gauche, il est prévu un secteur cranté 121, monté solidaire d'un levier défini par un bras principal 125, et un bras perpendiculaire 124, tous deux fixés sur la partie non crantée du secteur 121. L'extrémité libre du bras 125 est munie d'un moyen de fixation ou fermoir, par exemple comme suit : un bouton moleté 127 est solidaire d'un axe dont la partie terminale filetée 128 peut venir s'introduire dans un alésage 129 que comporte le montant 104 de l'appareil 100.

Dans la position ouverte à l'extrême du levier 125, illustrée en trait d'axe sur la figure 5, la queue 124 dudit levier vient en appui sur un épaulement 107. L'angle d'ouverture est alors supérieur à un angle droit, par exemple égal à 108°.

Le levier 125 est normalement rappelé dans cette position par un ressort 122, qui prend appui dans les plaques horizontales 123-1 ou 123-2, suivant le cas, qui délimitent les logements 130. Le ressort 122 s'enroule sur l'axe 120 des secteurs crantés 121, pour finir par une branche prenant appui sur la face interne du levier 125 concerné.

La figure 4B fait encore apparaître des vis 105 et 106 qui permettent le montage de l'ossature interne définissant les deux logements 130-1 et 130-2 de l'appareil.

L'introduction d'un module de mémoire par un usager peut s'effectuer d'une seule main, comme suit:

- d'une main l'usager introduit le module de façon qu'il vienne glisser sur les languettes 111 et 112, jusqu'à ce que le segment de crémaillère SC21 commence à engrener sur le secteur cranté 121. Il lâche alors le module.

- Par la manoeuvre du levier 125, le module est alors poussé pour s'enficher d'abord sur les pions de centrage PC11 et PC12, puis, par son élément de connecteur C1, venir en prise sur l'élément de connecteur femelle C2, cette opération étant achévée lors de la fermeture complète du levier 125, qui peut alors être verrouillé par vissage de la vis 128 à l'aide du bouton moleté 127.

Cette réalisation résoud élégamment le problème posé, et sur lequel il convient de revenir brièvement.

Ce problème consiste en effet à réaliser des mémoires modulaires de grande taille, susceptibles d'être fiables, de faible volume, et de bien tenir dans des conditions d'environnement extrême.

Dès lors que le module de mémoire est de grande taille, il nécessite un connecteur qui possède, en correspondance, un grand nombre de broches.

Pour répondre aux autres impératifs rappelés ci-dessus, la Demanderesse a observé que l'effort à appliquer sur le connecteur était de l'ordre de 110 Newtons. La réalisation d'un système qui puisse être manipulé d'une seule main et qui satisfasse à ces impératifs, en même temps qu'à ceux de fiabilité et aux autres impératifs sus-men ionnés est délicate. La présente invention apporte une solution intéressante à ce problème.

Jusqu'à présent,on a décrit le dispositif dans la position illustrée sur la figure 1. Il va de soi qu'en
pratique les logements des modules de mémoire pourront
s'ouvrir vers le haut ou vers le bas.

On s'intéressera maintenant aux parties électroniques
du dispositif selon l'invention.

Bien que différents autres types de mémoires électroniques puissent être utilisés, la Demanderesse a observé qu'il est largement préférable d'utiliser, à
l'intérieur des modules de mémoire, des circuits hybrides composés de puces de circuits intégrés du type
EEPROM. Il est apparu en effet que ce type de mémoire
permet à l'heure actuelle un cycle d'écriture d'1
milliseconde par mot, ou de 10 millisecondes par groupe de 16 mots (de 8 bits). De plus, ce cycle d'écriture peut être divisé par 8 si l'on écrit de façon
séquentielle dans des puces équipées de registres tampon d'écriture, auquel cas l'écriture d'une cassette
de 128 kilos-mots (de 16 bits) nécessite un temps de
10 à 16 secondes environ. Pour sa part, le cycle de
lecture est de l'ordre de quelques centaines de nanosecondes.

On peut alors aisément obtenir une capacité de 128
kilos-mots de 16 bits en utilisant 32 puces de 64
kilos-bits, telles que celles fournies actuellement
par Advanced Micro Devices, Intel, Xicor, ou SEEQ.

Dans un volume de 100 x 100 x 23 mm, on peut réaliser
une capacité de base de 128 kilos-mots de 16 bits, qui
peuvent être extensibles à 256, 512 ou 1024 kilos-
mots de 16 bits.

On décrira maintenant en référence à la figure 6 un mode de réalisation dans lequel la cassette de mémoire est constituée de 128 kilos-mots de 16 bits.

La figure 6 fait encore apparaître la constitution détaillée de l'interface 20, ainsi que l'unité de traitement 30.

Un circuit de surveillance d'alimentation 29 établit un signal $\overline{RAZ}$ qui est adressé à un générateur de signaux de commande 201 que comporte l'interface 20. Il fournit également un signal de présence +5 volts appliqué à un circuit de protection à l'écriture 202. Ce circuit répond à la condition dans laquelle l'interrupteur de réceptacle de cassette IC10 indique que la cassette est bien enfichée, ce qui autorise l'échange d'informations avec la cassette (ou seulement l'écriture, la lecture étant alors toujours permise). Un interrupteur analogue détecte la position de la vis V10.

Suivant le cas, une autorisation d'écriture est adressée ou non par le circuit de protection 202 vers le générateur de signaux de commande 201.

Celui-ci est associé par ailleurs à trois registres :

- un registre de données à écrire 203,

- un registre de données lues 204,

- un registre d'adresses 205.

L'unité de traitement dialogue avec l'interface 20 par 17 lignes d'adresses, 16 lignes de données, une ligne de demande de cycle mémoire notée $\overline{DC}$, une ligne de signal de lecture/écriture notée L, une ligne de commande de bus de données notée $\overline{VSM}$, et une ligne de présence de données lues notée $\overline{RE}$.

Pour sa part, l'interface 20 dialogue avec le module de mémoire par 16 lignes d'adresses, 16 lignes de données, 8 lignes de signaux d'écriture $\overline{WS0}$ à $\overline{WS7}$, une ligne de signal d'effacement $\overline{CC}$, des lignes de validation des données, qui portent l'une sur le bit le moins significatif (signal $\overline{OELSB}$) et l'autre sur le bit le plus significatif ($\overline{OEMSB}$). Enfin, il est prévu un signal de décodage pour chaque bloc de 64 kilos-mots de 16 bits, ce qui donne donc deux signaux $\overline{CE1}$ et $\overline{CE2}$.

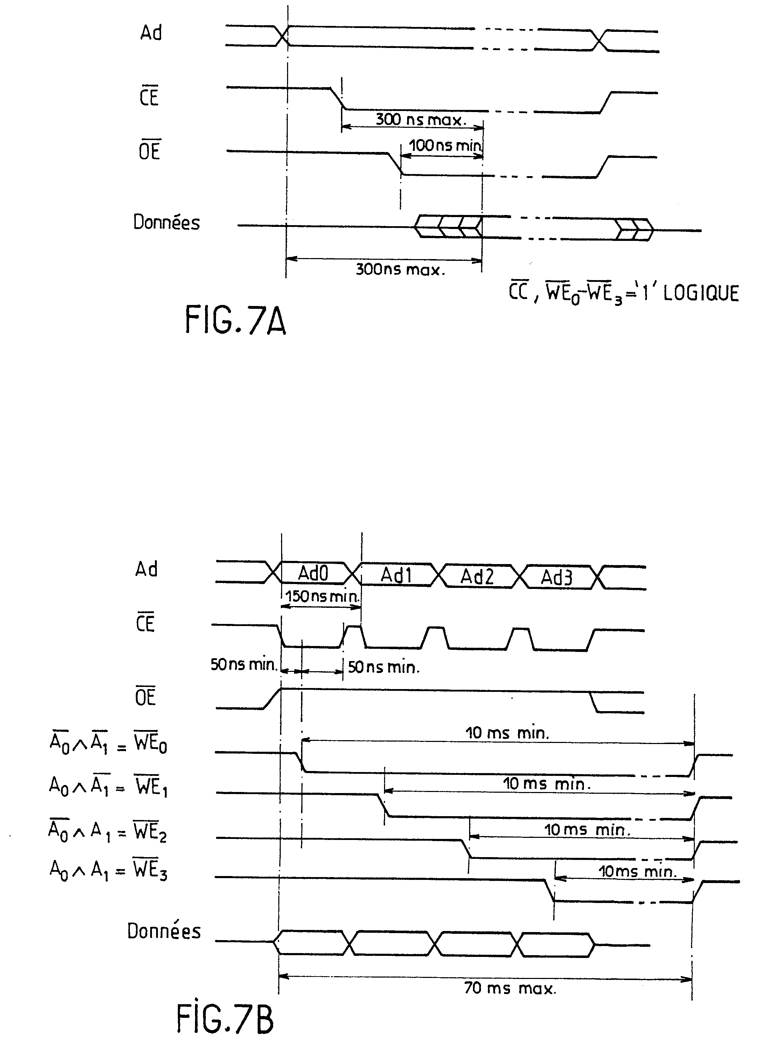

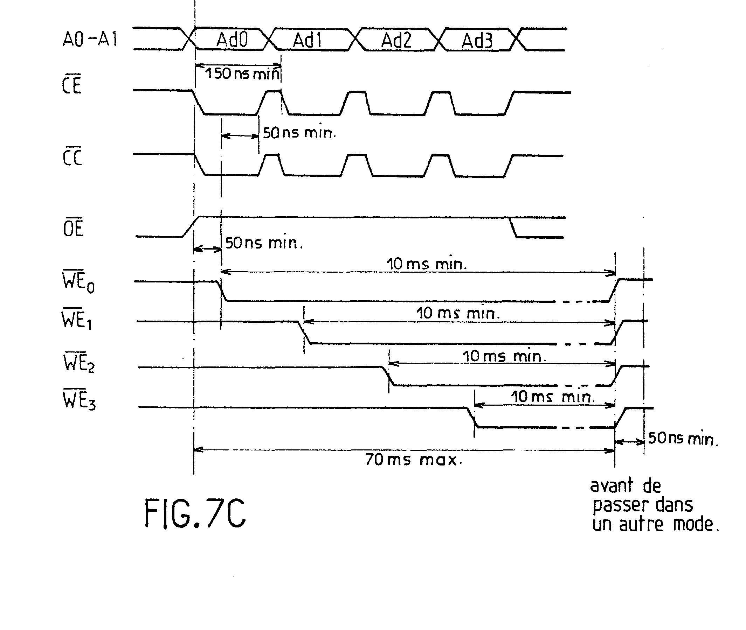

Les figures 7A, 7B et 7C montrent respectivement les chronogrammes de lecture, d'écriture et d'effacement dans une cassette de mémoire selon l'invention. Ces figures, qui sont incorporées à la description en tant que représentation optimale des opérations de lecture, d'écriture et d'effacement, peuvent être expliquées comme suit :

- en lecture (figure 7A) la présence de l'adresse et la mise au niveau bas de $\overline{CE}$ et $\overline{OE}$ permet l'apparition de l'information lue sur les parties de la cassette. $\overline{CC}$ et les signaux $\overline{W0}$ à $\overline{W7}$ doivent rester au niveau haut.

- en écriture (figure 7B) en écriture, l'adresse, la quantité à écrire et les signaux de commande, $\overline{CE}$, $\overline{CC}$, $\overline{DE}$ sont chargés dans des registres d'entrée des composants EEPROM, par exemple par le front descendant du signal $\overline{W}$. La cassette reçoit 8 signaux de commande d'écriture différents, $\overline{W0}$

à $\overline{W7}$, qui rendent possible l'écriture simultanée de 8 mots dans la cassette. Ces signaux doivent avoir la durée nécessaire pour assurer l'écriture (par exemple 10 ms pour certains composants).

- effacement (figures 7B et 7C) suivant les composants, l'effacement qui doit nécessairement être réalisé préalablement à toute écriture peut être effectué :

. soit automatiquement dans le composant mémoire;

. soit sous la forme d'un cycle d'écriture particulier dans lequel les entrées de quantité ou données du composant sont mises au niveau haut.

Certains types de composants EEPROM peuvent être effacés par boîtier plutôt que mot à mot. La figure 7C montre cet exemple : le signal $\overline{CC}$ au niveau bas lorsqu'un cycle d'écriture est lancé indique que le composant mémoire doit être intégralement effacé.

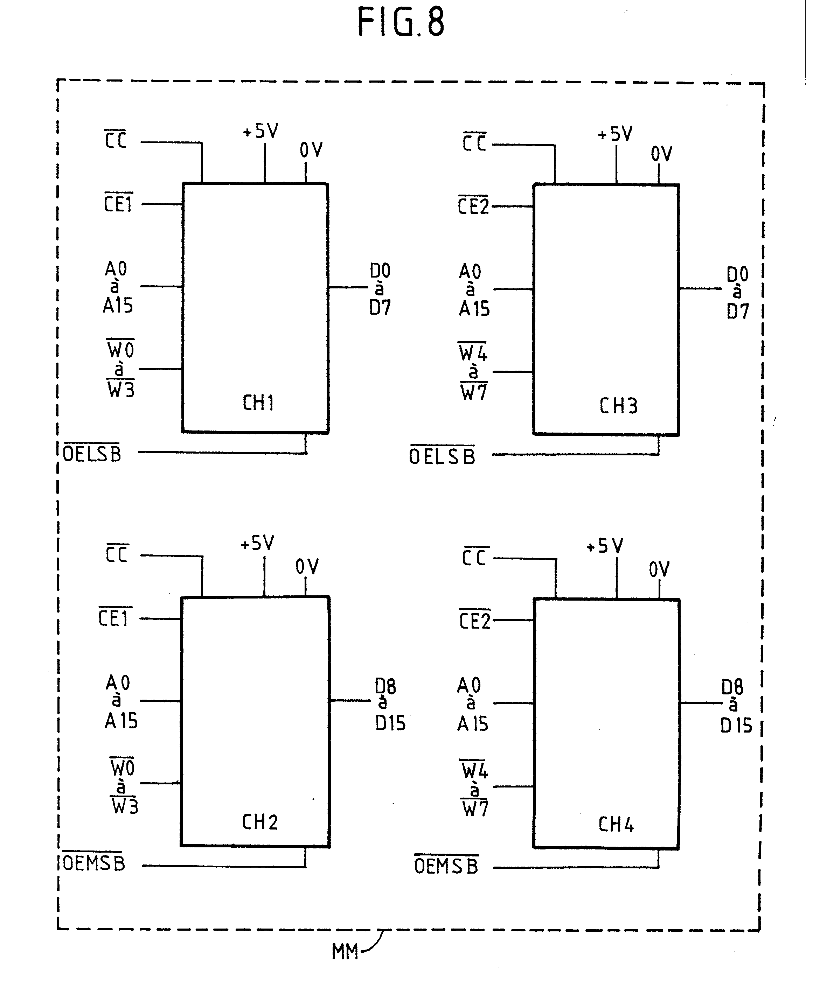

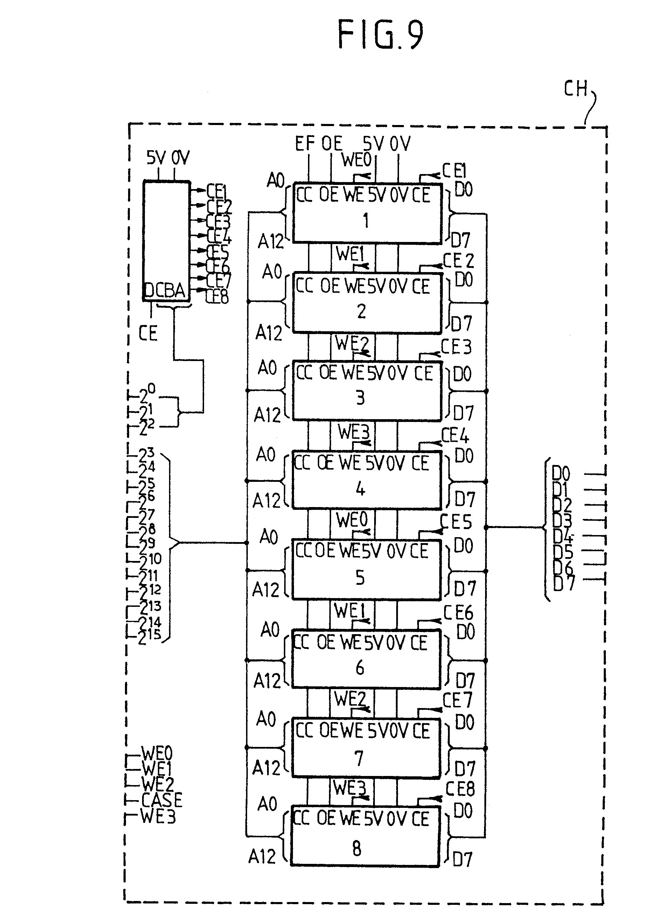

Les figures 8 et 9 montrent respectivement des possibilités d'interconnexion des puces à l'intérieur d'un hybride et des hybrides à l'intérieur d'une cassette.

La figure 8 fait apparaître une cassette composée de quatre circuits hybrides CH1 à CH4, dont chacun présente la composition illustrée sur la figure 9, avec les notations

. A0 - A15 pour les adresses,

. D0 - D7 (ou D8 - D15) pour les données,

. CE pour sélection de boîtier ou de puce (chip Enable), étant observé que, sur la figure 9, CE est combiné avec les 3 premiers fils d'adresse pour décodage aux fins de sélection des puces élémentaires,

. OE pour validation de sortie, le cas échéant pour les bits les plus (MSB) ou les moins (LSB) significatifs,

. W ou WE pour autorisation d'écriture, et

. EF ou CC pour effacement.

Dans une version simplifiée de l'invention, il suffirait de la carte d'interface 20, et d'une carte de connexion vers un bus extérieur.

Il est toutefois considéré actuellement comme préférable d'incorporer à l'appareil une unité de traitement 30 et ses mémoires propres 31, ceci permettant une gestion locale du contenu des modules de mémoire.

Il est alors possible d'accéder aux modules de mémoire non seulement par adressage direct, mais aussi par différents modes d'adressage indirects, ou même par un adressage de fichier, dans la mesure où une liste de fichiers convenable est introduite à un emplacement convenu de chaque cassette de mémoire.

Revendications.

1. Dispositif pour l'enregistrement et la lecture d'informations,

du type dans lequel un organe de mémoire électronique modulaire (MM1,MM2), en forme de boîtier parallélépipédique plat,peut être mis en coopération avec un appareil de lecture/écriture (100), pourvu d'un logement propre à recevoir ledit boîtier,

caractérisé en ce que l'organe de mémoire (MM1, MM2) est composé de circuits intégrés hybrides équipés de puces de mémoire électronique, définissant une capacité de mémoire d'au moins 0,25 Mégabit, environ,

en ce que le boîtier comporte en partie arrière un connecteur mâle (C1), relié à ses circuits hybrides internes, et possédant au moins 8 broches de données, 15 broches d'adresse, 4 broches d'écriture,ainsi que des broches d'alimentation, d'effacement et de validation,

ce connecteur mâle (C1) étant propre à coopérer avec un connecteur femelle homologue (C2), monté flottant au fond du logement de l'appareil de lecture/écriture (100),

en ce que le boîtier comporte sur ses petites faces latérales (11, 12) des glissières (R11, R12), dont au moins une partie est électriquement conductrice, et qui sont propres à coopérer avec les organes de guidage (111, 112) montés en regard dans ledit logement et pourvus de parties conductrices venant au contact de celles des glissières, et reliées à la masse de l'appareil (100),

en ce que des moyens de centrage coopérants sont prévus sur le boîtier (P11,P12) et dans le logement de l'appareil (PC11, PC12), de part et d'autre de leurs connecteurs respectifs (C1, C2),

en ce que le boîtier de mémoire (MM1, MM2) porte, à l'extrémité avant de l'une (R21) de ses glissières, un segment de crémaillère (SC21), propre à coopérer avec un segment de roue dentée (121) monté à rotation, en regard, dans l'appareil de lecture/écriture (100), lequel comporte en outre des moyens (125) de commande de la roue dentée permettant la mise en place et l'extraction du boîtier de mémoire (MM1, MM2),et

en ce que l'appareil de lecture/écriture (100), qui comprend des moyens électroniques (20) de lecture/écriture dans lesdits circuits hybrides, est muni d'au moins un détecteur (IC10) de la présence du boîtier de mémoire en position complètement enfichée, lequel détecteur interdit dans le cas contraire (202) toute écriture d'informations dans le boîtier de mémoire, de préférence tout échange d'informations avec celui-ci.

2. Dispositif selon la revendication 1, caractérisé en ce que les puces sont des mémoires du type EEPROM, assorties de registre— tampon d'écriture et organisées en mots d'au moins huit bits.

3. Dispositif selon la revendication 2, caractérisé en ce que les puces sont organisées en au moins 128 Kmots de 16 bits.

4. Dispositif selon l'une des revendications 1 à 3, caractérisé en ce que les glissières, parallèles à un plan principal du connecteur, sont constituées de rainures latérales (R21, R22) du boîtier, coopérant avec des languettes homologues (121, 122) de son logement (130).

5. Dispositif selon la revendication 4, caractérisé en ce que le logement (130) de l'appareil comporte, en son entrée, et à l'opposé du segment de roue dentée (121), un galet libre (110) propre à coopérer avec la glissière sans crémaillère (R22) du boîtier.

6. Dispositif selon l'une des revendications 4 et 5, caractérisé en ce que les moyens de centrage, placé au voisinage du même plan principal, comprennent des tétons (PC11, PC12) du logement (130), propres à coopérer avec des orifices (P11, P12) du boîtier (MM).

7. Dispositif selon l'une des revendications 1 à 6, caractérisé en ce que les moyens de commande du segment de roue dentée comprennent un levier (125), muni d'un rappel élastique (122) à l'ouverture, et propre à se loger avec fixation (127-129) sur la face avant de l'appareil, en position de fermeture.

8. Dispositif selon l'une des revendications 1 à 7, caractérisé en ce que le boîtier (MM) comporte un organe à deux positions (V10) et en ce qu'il est prévu dans le logement (130) un palpeur propre à détecter la position de cet organe.

9. Dispositif selon la revendication 8, caractérisé en ce que l'organe à deux positions est une vis (V10) montée à l'arrière (10) du boîtier (MM).

10. Dispositif selon l'une des revendications 8 et 9, caractérisé en ce que l'organe à deux positions (V10) interdit ou autorise l'écriture dans le module de mémoire,qui peut contenir du logiciel ou des données.

11. Dispositif selon l'une des revendications 1 à 10, caractérisé en ce qu'il comporte plusieurs logements adjacents pouvant recevoir des modules de mémoire respectifs (MM1, MM2).

12. Dispositif selon l'une des revendications 1 à 11, caractérisé en ce que les moyens électroniques de lecture/écriture comportent une unité (20) formant interface avec le ou les modules de mémoire, et une unité (32) de connexion avec un bus externe.

13. Dispositif selon l'une des revendications 1 à 12, caractérisé en ce que les moyens électroniques de lecture/écriture comprennent une unité de traitement (30) avec son unité de mémoire propre (31), ce qui permet une gestion locale des modules de mémoire.

14. Dispositif selon la revendication13, caractérisé en ce que l'unité de traitement (30) permet l'accès au module de mémoire par adressage direct, par adressage indirect, ou par adressage de fichiers.

100

101

MM1

MM2

109

102

FIG.1

13

R22

R21

11

12

P11

10

C1

P12    V10

FIG.2

FIG. 3É

FIG.3B

FIG.3A

FIG.3D

FIG.3C

FIG.4A

FIG.4B

0 188 968

FIG.5

FIG.6

**0 188 968**

FIG.7A

$\overline{CC}$, $\overline{WE}_0$-$\overline{WE}_3$='1' LOGIQUE

FIG.7B

FIG.7C

avant de
passer dans
un autre mode.

# FIG.8

$\overline{CC}$

+5V

0V

$\overline{CE1}$

A0
à
A15

D0
à
D7

$\overline{W0}$
à
$\overline{W3}$

CH1

$\overline{OELSB}$

$\overline{CC}$

+5V

0V

$\overline{CE2}$

A0
à
A15

D0
à
D7

$\overline{W4}$
à
$\overline{W7}$

CH3

$\overline{OELSB}$

$\overline{CC}$

+5V

0V

$\overline{CE1}$

A0
à
A15

D8
à
D15

$\overline{W0}$
à
$\overline{W3}$

CH2

$\overline{OEMSB}$

$\overline{CC}$

+5V

0V

$\overline{CE2}$

A0
à
A15

D8
à
D15

$\overline{W4}$
à
$\overline{W7}$

CH4

$\overline{OEMSB}$

MM

# FIG.9

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| A | IBM TECHNICAL DISCLOSURE BULLETIN, vol. 23, no. 5, octobre 1980, pages 1748-1750, New York, US; M.I. DAVIS: "Solid-state cartridge system" * Page 1749, ligne 15 - page 1750, ligne 11; figures 1,2 * | 1,11 | G 11 C 5/00 G 06 F 1/00 H 05 K 7/14 |
| A | FR-A-2 344 301 (ITT) * Page 9, ligne 36 - page 11, ligne 18; figures 1-3 * | 1,6,7 | |
| A | US-A-4 454 552 (GENERAL ELECTRIC) * Colonne 2, lignes 13-29; figure 1 * | 1 | |
| A | IBM TECHNICAL DISCLOSURE BULLETIN, vol. 1, no. 2, août 1958, page 8, New York, US; A. RUSSIN: "Compensating hinge" * En entier * | 1 | |
| A | FR-A-2 385 239 (BUNKER RAMO) * Revendication 1; figures 1,2 * | 1 | |
| A | IBM TECHNICAL DISCLOSURE BULLETIN, vol. 25, no. 4, septembre 1982, pages 1980-1981, New York, US; J.A. CRAFT: "Low cost cartridge code detector" * En entier * | 1 | |

DOMAINES TECHNIQUES RECHERCHES (Int. Cl.4)

G 11 C
G 06 F
H 05 K
H 01 R
G 11 B

Le present rapport de recherche a été établi pour toutes les revendications

| Lieu de la recherche | Date d'achèvement de la recherche | Examinateur |
|---|---|---|
| LA HAYE | 17-03-1986 | NUSSBAUMER C.P. |